# EUROPEAN PATENT APPLICATION

(11) **EP 4 542 852 A1**
(43) Date of publication of application: **23.04.2025**
(21) Application number: 24206591.0
(22) Date of filing: 15.10.2024
(51) Int. Cl.: H02S 20/30, H10F 19/00

(54) **PHOTOVOLTAIC MODULE INSTALLATION STRUCTURE**

(30) Priority: 18.10.2023 IT 202300021705
(71) Applicant: Solbian Energie Alternative S.r.l., 10051 Avigliana (Torino) (IT); PETRA STROJI PROIZVODNJA, STORITVE TRGOVINA, D.O.O., 1000 Ljubljana (SI); Marfin Management S.A.M., 98000 Monaco (MC)
(72) Inventor: ROGELJA, Jure, 9800 MONACO (MC); BRIC, Ale, 1000 LJUBLJANA (SI)
(74) Representative: Vanzini, Christian

(57) **Abstract**

Photovoltaic module installation structure, comprising a pair of parallel rails (11) configured to be fastened to a support surface (S), and a planar support element (13) mounted onto the rails (11), whereupon at least one photovoltaic module (1) is fastened. Each of the lateral sides (13c, 13d) of the planar support element (13) comprises a pair of pins (13c', 13c", 13d', 13d") resting upon the respective rail (11). The planar support element (13) is rotatable with respect to the rails (11), about a tilting axis (y) defined by the pins (13c', 13c", 13d', 13d"), the tilting axis (y) being slidable along the rails (11) in such a way that the planar support element (13) is tiltable between a working position, wherein the photovoltaic module (1) is exposed, and a protective position, wherein the photovoltaic module (1) is hidden.

## Description

### FIELD OF THE INVENTION

The present invention relates to photovoltaic modules.

### BACKGROUND

Currently, the benefits of solar energy are well known. Electricity production with such clean, renewable, fossil-fuel-free energy is increasingly popular. In recent years, photovoltaic technology has become increasingly accessible due to improvements in efficiency, reductions in production costs linked to the increase in volumes and state incentives. On the other hand, the climate crisis is pushing governments and industry to seek a rapid decarbonization of most human activities. Freight transport is one of the main factors contributing to greenhouse gas emissions, and land and maritime transport companies are being pushed to reduce their carbon footprint within the coming years. Solar energy may make an important contribution to achieving this goal, but those photovoltaic modules that are used on a large scale are not suitable for mobile use and within work areas. Standard photovoltaic modules with an aluminum frame and a glass surface are heavy, difficult to handle, and the glass may break with consequent problems regarding safety. In order to ensure that the system has reduced weight and may be easily utilized by the crew on board, and also in order to minimize the risk of breakage, flexible and lightweight photovoltaic modules will be used that are constructed without a front glass and without a frame.

Insofar as solar energy density is low when compared to the energy requirements for transport, we must also add that the contribution of solar energy may only be significant when there is sufficient space available. Bulk carriers in maritime transport are a good example wherein the abundance of space may allow for large solar installations, but wherein loading and unloading operations must be taken into account for the operation and safety of photovoltaic modules. Bulk carriers are widely used and have a flat deck wherein large hatches are implemented in order to allow for the loading and unloading of dry material such as minerals, coal, wheat, etc. The hatch covers offer ample space for the installation of the solar system but are also the surfaces most exposed to impact during operations, particularly due to the load falling or coming into contact with the handling equipment (cranes, etc.).

Solutions to this problem have been envisaged. An example is described in the document JP2015205604A, which considers a bulk carrier ship wherein the hatch lids are of the bendable type. In this case, when the hatch is open, half of the cover is facing towards the loading area, while the other half is facing in the opposite direction, thus being protected from damage. The aforesaid solution solves the problem of protecting the photovoltaic modules by installing them only on the cover area that is not facing the loading area. This solution obviously greatly reduces the space available for the installation of photovoltaic modules, thus preventing optimal utilization of the surfaces.

There are also examples in the literature of movable and rotating solar panels in the marine field, wherein the movement thereof has the purpose of increasing energy production by optimizing the orientation of the panels towards the sun thereby protecting them from the wind and waves, or avoiding the reflection of light towards sensitive areas (control room or towers). See for example documents CN111464127A, KR20160018967A, CN107618621A, JP2011142261A.

One object of the present invention is to offer a solution that allows for greater use of those surfaces that are available on the decks of merchant ships in order to allow for the installation of a greater number of photovoltaic modules than the solution known from JP2015205604A. More generally, another object of the invention is to provide a solution that allows photovoltaic modules to be protected in certain situations, thus allowing them also to be installed within areas wherein, due to the relative risk of damage due to impacts, such installation is normally not recommended.

### SUMMARY OF THE INVENTION

According to the invention, a structure for installing photovoltaic modules is provided, comprising a pair of parallel rails configured to be fastened to a support surface, and a planar support element mounted upon the rails whereto at least one photovoltaic module is fastened, the planar support element comprising a pair of end sides and a pair of lateral sides, each of the lateral sides being coupled to one of the respective rails,
wherein each of the rails comprises a rail side extending along a longitudinal direction of the rail and facing the respective lateral side of the planar support element,
wherein each of the lateral sides of the planar support element comprises a pair of pins respectively arranged at or near the end sides of the planar support element, said pins extending laterally from the respective lateral side of the planar support element and resting upon the rail side of the respective rail,
wherein the planar support element is rotatable with respect to the rails, about a tilting axis defined by the pins and parallel to the end sides of the planar support element and arranged near or at one of the end sides of the planar support element, said tilting axis being slidable upon the rail side so that the planar support element is tiltable between a working position, wherein said at least one photovoltaic module is exposed, and a protective position, wherein said at least one photovoltaic module is hidden.

The aforesaid installation structure allows for quick and easy protection of the modules by changing the orientation of the photovoltaic modules, i.e., overturning them. In this way, the surface of the solar panel which is active and sensitive to damage will remain protected during operations with a high probability of impacts, such as cargo loading and unloading operations, as well as being protected from dust and weather.

The installation structure is also designed to have the least thickness possible and to remain flat on the relevant support surface, in such a way as to prevent - as far as possible - waves and wind from penetrating below the installation structure.

### DETAILED DESCRIPTION OF THE INVENTION

The present invention will be better described by a preferred embodiment, which is provided by way of a non-limiting example and with reference to the accompanying drawings, wherein:
Fig. 1 is a schematic cross-sectional view of a portion of a photovoltaic module;
Fig. 2 is a perspective view of an installation structure for photovoltaic modules, in the working position;
Fig. 3 and 4 are enlarged scale views of details respectively denoted by III and IV in Fig. 2;
Fig. 5 is a plan view of a planar support element of the installation structure;
Fig. 6 is a cross-sectional view of the installation structure taken along the line VI-VI of Fig. 5;
Fig. 7 is an enlarged scale view of a detail denoted by VII in Fig. 5;
Fig. 8 is an enlarged scale view of a detail denoted by VIII in Fig. 6;
Fig. 9 and 10 are, respectively, a perspective view and a side elevation view of the installation structure, during a tilting movement;
Fig. 11 is an enlarged scale view of a detail denoted by XI in Fig. 9;
Fig. 12 and 13 are, respectively, a perspective view and a side elevation view of the installation structure in the protective position;
Fig. 14 is an enlarged scale view of a detail denoted by XIV in Fig. 13;
Fig. 15 is a side elevation view of the installation structure in the position of Fig. 2; and
Fig. 16 and 17 are sectional views of the installation structure taken respectively along the lines XVI-XVI and XVII-XVII of Fig. 15.

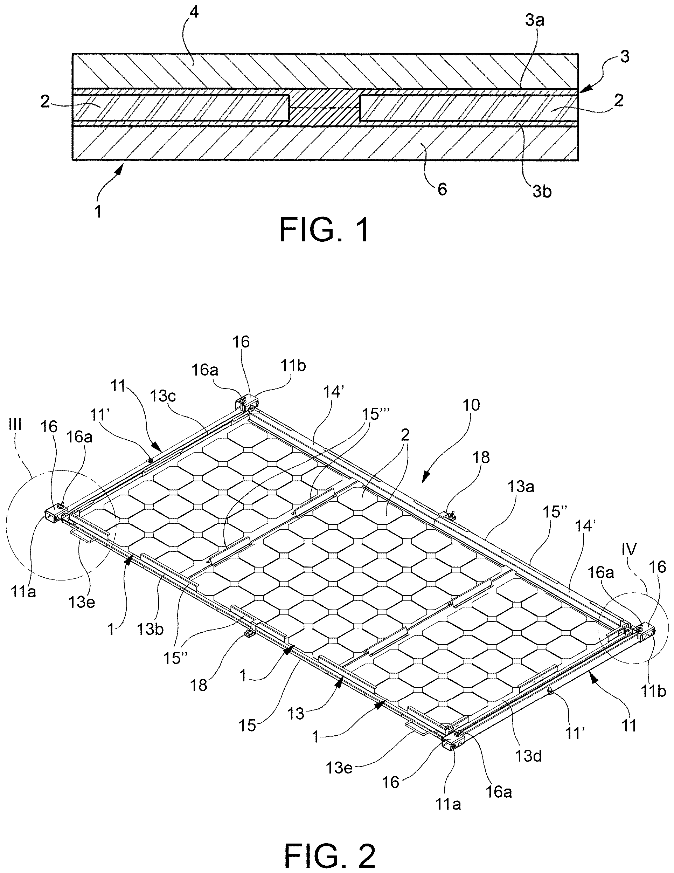

Fig. 1 shows a diagram of the layers that make up an example of a photovoltaic panel that may be used in the installation structure according to the invention and which is particularly suitable insofar as it is devoid of glass and therefore safer in the case of breakage.

According to the layer diagram shown in Fig. 1, the glassless photovoltaic module, which is denoted as a whole by the reference numeral 1, essentially comprises
- a plurality of photovoltaic cells 2 which are arranged side by side, in particular the cells being made of mono- or poly-crystalline silicon. According to a preferred embodiment, the photovoltaic cells 2 are "back-contact" cells wherein all of the electrical contacts (not shown) are formed on the back of the cell;
- at least one encapsulating layer 3 which is made of a thermoplastics material and is suitable for containing the photovoltaic cells 2 therein, such encapsulating layer being formed by a first and by a second layer 3a, 3b which are arranged on opposite sides of the photovoltaic cells 2 and fused around said cells;
- at least one front layer 4 which is joined to and overlapping with the encapsulating layer 3 on a first surface thereof, such front layer 4 being exposed in use to sunlight, such at least one front layer 4 being made of a plastics material and being at least in part of a material that is resistant to ultraviolet and in general to atmospheric agents; and
- at least one back layer 6 which is joined to and overlapping with this encapsulating layer 3 on a second surface thereof that is opposite said first surface.

According to an embodiment which is not shown, the back layer 6 may be absent.

In this description, the terms "front" and "back" refer to the usage condition of the photovoltaic panel. A "front" layer is oriented toward the sunlight, and is located between the light source and the encapsulating layer containing the photovoltaic cells. A "back" layer, however, is located on the opposite side of the encapsulating layer containing the cells.

Such glassless photovoltaic module is produced according to conventional production techniques, i.e. by means of the following steps:
- selecting the photovoltaic cells on the basis of electrical parameters;
- welding the photovoltaic cells to one another in such a way as to form rows of electrically connected cells which are known as strings. Such welding takes place using tinned copper metal parts, which ensure good electrical conductivity;
- assembling said strings in regular shapes, typically rectangles, in order to form a photovoltaic module having the desired dimensions, while simultaneously forming the electrical contacts wherethrough the generated current is extracted from the finished module;
- overlapping the various layers according to the arrangement in Fig. 1;
- laminating in a flat vacuum laminating machine, in accordance with a temperature cycle that depends upon the materials used.

Lamination requires a typical cycle time of 10-20 minutes, and is currently the most reliable, fast and economic process for producing photovoltaic modules based on poly- or monocrystalline silicon cells.

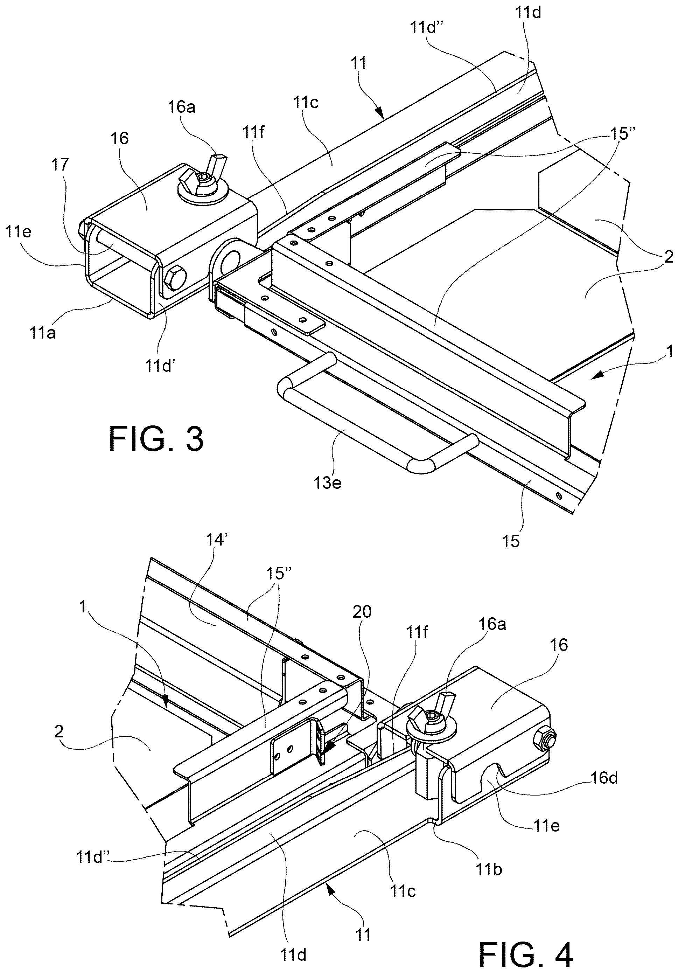

With reference now to Fig. 2 to 17, an installation structure 10 will now be described, by means whereof one or more of the photovoltaic modules 1 may be installed within an installation area, which may be, for example, the deck of a merchant vessel. Given the lightness and robustness of the photovoltaic modules described above they are particularly suitable for being combined with the installation structure 10. It is understood however that the invention is not limited to the photovoltaic modules described above, and more generally it is not limited to glassless photovoltaic modules.

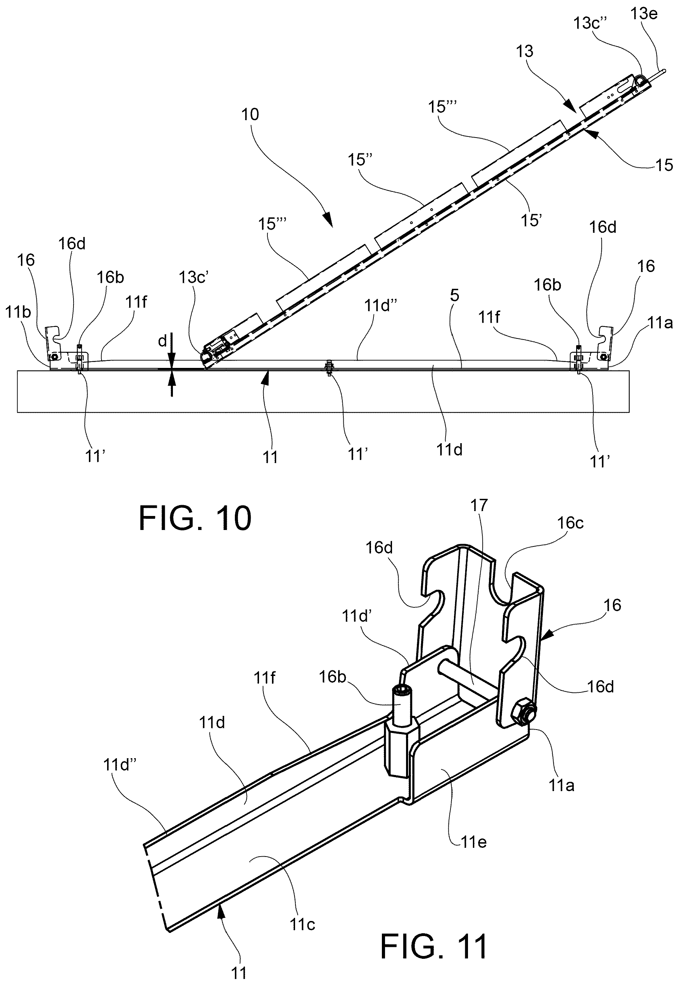

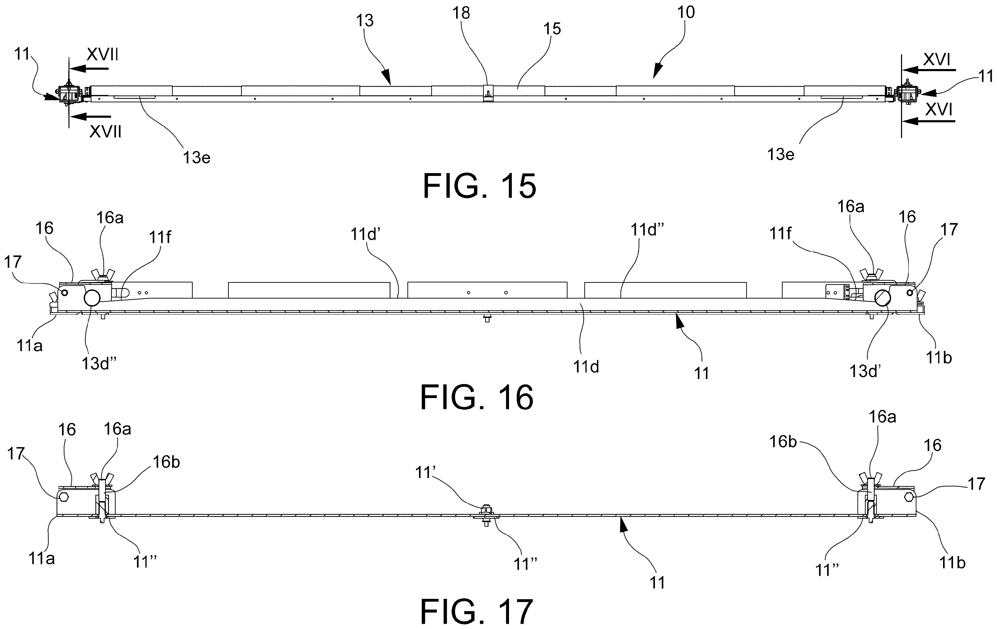

The installation structure 10 comprises a pair of parallel rails 11 configured to be fastened to a support surface S, which may for example be a surface of the deck or of the door of a hatch of a merchant ship. In the example shown, such rails 11 are attached to the support surface by means of bolts 11' provided with spacer washers 11" (see also Fig. 10 and 17) so as to define a gap d between the rails 11 and the support surface S in order to facilitate water drainage. In the example shown, the rails 11 consist of profiles which will be described in more detail below.

The installation structure 10 further comprises a planar support element 13 mounted upon the rails 11, and whereto one or more photovoltaic modules 1 are fastened (in the example, these are three photovoltaic modules). Specifically, the planar support element 13 comprises a base plate 14 and a protection frame 15 arranged along the edge of the base plate 14. The protection frame 15 has the functions of reinforcing the base plate 14 and protecting those photovoltaic modules 1 that are arranged upon the base plate 14. In particular, the protection frame 15 acts as a spacer when the planar support element 13 is upside down.

In one embodiment, the electronics and connectors of the photovoltaic modules 1 (not shown) are arranged on the rear side of the photovoltaic modules 1 in order to protect them from exposure. The base plate 14 comprises a plurality of notches and channels (not shown) that are obtained upon the front side thereof and configured so as to receive the electronics and cables of the photovoltaic modules 1. The thickness of the base plate 14 must therefore be sufficient to accommodate the aforementioned components of the photovoltaic panels. In this way, the electronics and cables are less exposed to the environment and better protected.

According to an alternative embodiment, the electronics and connectors of the photovoltaic modules 1 (not shown) may be arranged upon the front side of the photovoltaic modules 1. In this case, the base plate 14 may be thinner.

The base plate 14 should be robust, lightweight, and made of water- and ultraviolet-resistant and flame-retardant material. A preferred material is, for example, water-resistant plywood, insofar as it is a sustainable, recyclable and carbon sink material. On the rear side thereof the base plate 14 may be coated with rubber in order to improve the electrical insulation.

In the example shown, the photovoltaic modules 1 are also provided with respective junction boxes (not shown) arranged along respective edges of the photovoltaic modules 1. In order to protect such junction boxes and hold the relative cables in place, cover elements 14' are fastened onto the base plate 14 at one of the edges of the base plate 14.

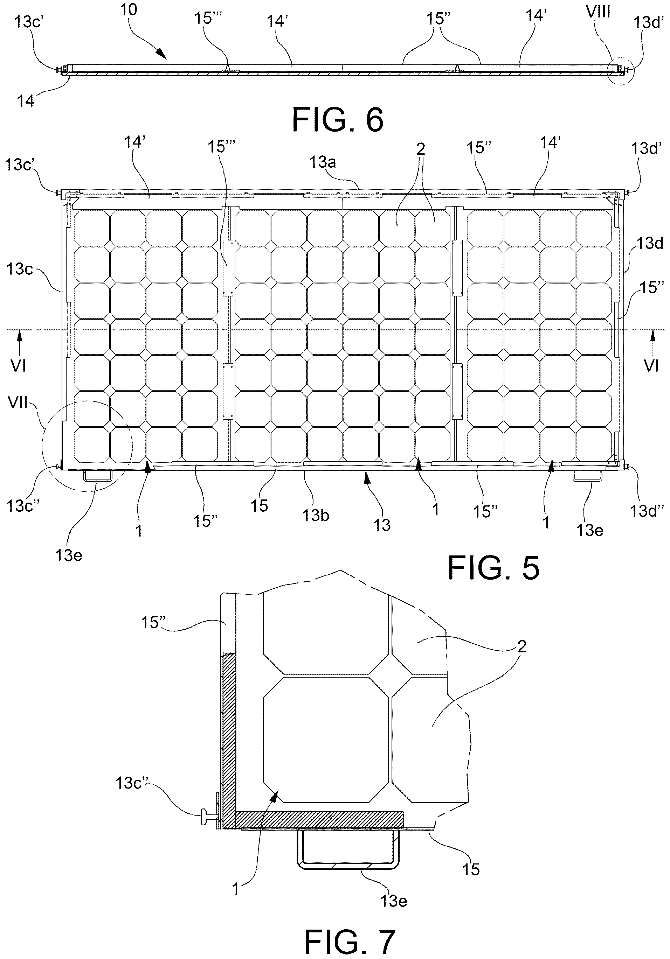

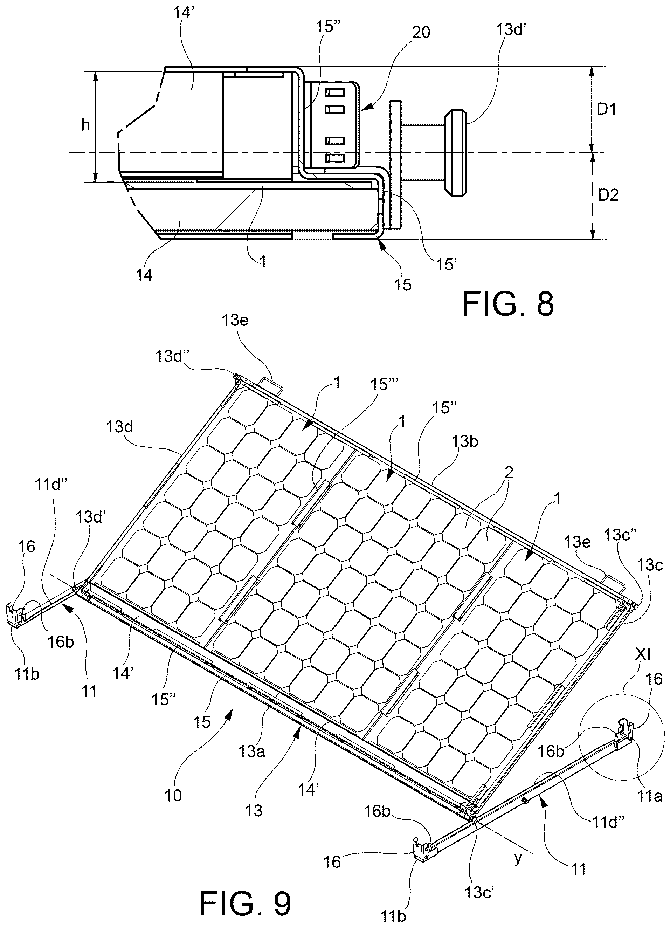

The protection frame 15 comprises a plurality of frame profiles that are fastened therebetween and arranged along the perimeter of the base plate 14. As may be seen in Fig. 8, the cross-sectional profile of the protection frame 15 comprises a C-shaped portion 15' extending substantially along the entire length (perimeter) of the protection frame 15, and a plurality of L-shaped fins 15" extending along partial segments of the length (perimeter) of the protection frame 15. The C-shaped portion 15' is arranged so as to encompass one edge of the base plate 14 and of the respective photovoltaic module 1 arranged upon the base plate 14. In this way, the C portion 15' holds the photovoltaic modules against the base plate 14. The peripheral part of the photovoltaic module 1, engaged inside the C-shaped portion (represented by a dashed area in Fig. 7), will be a plastics part that is devoid of the photovoltaic cells and the electrical connections thereof. The L-shaped fins 15" extend from the C-shaped portion 15' in a direction perpendicular to the base plate 14 and protrude with respect to the front surface of the photovoltaic modules 1 by a distance h. The L-shaped fins 15" have a spacer function for protecting the front surface of the photovoltaic modules 1.

Support profiles 15‴ may also be arranged along the edges of the photovoltaic modules 1 between one photovoltaic module and another.

The positioning of the photovoltaic modules 1 upon the planar support element 13, more precisely upon the base plate 14, is such that one face of the planar support element 13 exposes the photovoltaic modules 1, in particular the active part thereof consisting of the photovoltaic cells 2 (see Fig. 2 and 5-6), and the opposite face shows the back of the base plate 14, and therefore the inactive but structurally more robust part (see Fig. 12-13).

From a geometric point of view, the planar support element 13 has a substantially rectangular shape and comprises a pair of end sides 13a, 13b and a pair of lateral sides 13c, 13d. Each of the lateral sides 13c, 13d of the planar support element 13 is coupled to a respective one of the rails 11.

Referring specifically to Fig. 9 and 11, each rail 11 has an L-shaped cross section along almost the entire length thereof, and a C-shaped cross section at the ends 11a, 11b thereof. In each rail 11, a bottom side 11c facing towards the support S and a rail side 11d extending vertically from the bottom side 11c may be identified, alongside a respective lateral side 13c, 13d of the planar support element 13. At each of the ends 11a, 11b, each rail 11 comprises a pair of wings 11d', 11e extending vertically from the bottom side 11c of the rail 11. A locking element 16 is hinged onto such wings 11d', 11e, which is connected to the respective end 11a, 11b of the rail 11 by means of a pin 17. The locking element 16 is rotatable about the pin 17, between a closed position (shown for example in Fig. 2 and 5-6) and an open position (shown for example in Fig. 9-11). The locking element 16 may be secured in the closed position by means of a fastening device, such as a wing nut 16a, which is screwed onto a threaded tip 16b fastened to the bottom side 11c of the rail 11. To this end, the locking element 16 has a central notch 16c which allows the locking element 16 to rotate without interfering with the threaded tip 16b. When the locking element 16 is in the closed position, the wing nut 16a (having a diameter greater than the width of the central notch 16c) may be screwed onto the threaded tip 16b in order to prevent the locking element 16 from being rotated to the open position thereof. The locking element 16 further comprises a pair of side wings wherein respective side notches 16d are obtained, the function of which will be clarified below.

Each of the lateral sides 13c, 13d of the planar support element 13 comprises a pair of flanged pins 13c'-13c", 13d'-13d" (visible in particular in Fig. 9) respectively arranged at or near the end sides 13a, 13b of the planar support element 13. The flanged pins 13c', 13c", 13d', 13d" extend laterally from the respective lateral sides 13c, 13d of the planar support element 13 and are configured so as to rest upon the upper edge 11d" of the rail side 11d of the respective rails 11. More specifically, the flanged pins 13c', 13c", 13d', 13d" are rigidly connected to the protection frame 15. As may be seen in Fig. 8, the flanged pins 13c', 13c", 13d', 13d" are arranged at a height whereby the distance D1 (in the direction perpendicular to the base plate 14) between the central axis of the single flanged pin 13c', 13c", 13d', 13d" and the furthest plane of the planar support element 13 on the front side (defined, in the example shown, by the L-shaped fins 15" of the protection frame 15) is equal to the distance D2 (in the direction perpendicular to the base plate 14) between the central axis of the single flanged pin 13c', 13c", 13d', 13d" and the furthest plane of the planar support element 13 on the rear side (defined, in the example shown, by a wing of the C-shaped portion 15' of the protection frame 15).

In the position of Fig. 2 and 5-6, the flanged pins 13c', 13c", 13d', 13d" are locked at the respective ends 11a, 11b of the rails 11, due to the fact that the locking elements 16 are in the closed position and that, in such position, the lateral notches 16d of such elements engage the flanged pins 13c', 13c", 13d', 13d" thereby preventing them from moving along the rails. An operator may free the flanged pins 13c', 13c", 13d', 13d" by unscrewing the wing nut 16a from each threaded tip 16b, and rotating the respective locking element 16 to the open position thereof.

Once the flanged pins 13c', 13c", 13d', 13d" are released, due to the arrangement described above, the planar support element 13 is rotatable relative to the rails 11 as shown in Fig. 9 and 10, about a tilting axis y defined by two of the pins, indicated in the drawings with 13c' and 13d'. It is therefore a tilting axis y parallel to the end sides 13a, 13ab of the planar support element 13 and arranged in proximity to, or at, one of said end sides 13a, 13b of the planar support element 13 (in the drawings this is the end side indicated with 13a). It should be noted that, with the arrangement described above, it would also be possible to rotate the planar support element 13 about another tilting axis defined by the other two pins, indicated by 13c" and 13d", near or at the other end side 13b. For manipulation of the planar support element 13 by an operator, at least one of the end sides 13a, 13b of the planar support element 13 is provided with handles 13e attached to the protection frame 15. In the example shown, the end side provided with the handles 13e is the end side 13b opposite the end side 13a where the covering elements 14', which are included for protecting the junction boxes of the photovoltaic modules 1, are arranged. This arrangement is used to prevent any damage to the cables during the tilting of the planar support structure 13.

Once the flanged pins 13c', 13c", 13d', 13d" are released, it is also possible to translate the tilting axis y by sliding the corresponding flanged pins 13c', 13d' along the upper edge 11d" of the rail sides 11d of the rails 11, as shown in Fig. 9 and 10, so as to move the tilting axis y from one end of the rails 11 to the other. In this regard, the inner wings 11d' at the ends of the rails 11 also have the end-of-travel function for the flanged pins 13c', 13d', 13c", 13d".

According to a preferred embodiment, the upper edge 11d" of the rail side 11d of each rail 11 comprises an inclined section 11f at each end 11a, 11b of the rail 11. Such inclined portion 11f extends upwards from the respective inner wing 11d' towards the remaining central part of the upper edge 11d". Therefore, pulling the flanged pins 13c', 13d' along the flanged portion 11f causes such flanged pins to rise slightly thereby facilitating the rotation of the planar support element 13 around said pins.

By virtue of the arrangement described above, the planar support element 13 is therefore tiltable between a working position (shown in Fig. 2 and 5-6) wherein the photovoltaic modules 1 are shown, and a protective position (shown in Fig. 12-13) wherein the photovoltaic modules 1 are hidden. In the working position, which may be exploited in particular when the ship is at sea, the photovoltaic modules 1 are able to produce electrical energy. In the protective position, the photovoltaic modules are protected, in particular during the loading/unloading steps of the ship. In this position, the photovoltaic modules do not produce electrical energy. When the photovoltaic modules 1 are in the working position or in the protective position, the planar support element 13 may be locked in position by closing the locking elements 16 on the respective flanged pins 13c', 13c", 13d', 13d" and tightening the respective wing nuts 16a so as to lock the locking elements 16 in the closed position. In this way, the flanged pins 13c', 13c", 13d', 13d" are locked in their respective positions thereby preventing any movement of the planar support element 13.

In the event that the planar support element 13 is of relatively large extension, in order to stabilize said element in the position reached, additional clamping elements 18 may be provided, arranged upon the support surface S (e.g., deck or door) at intermediate positions along the end sides 13a, 13b and/or along the lateral sides 13c, 13d, and maneuverable in order to anchor such sides to the support surface S.

The planar support structure 13 further comprises a fastening point 20 whereto the cables of the photovoltaic modules 1, present upon the planar support structure 13, are connected, and which is used for the electrical connection to the electrical system of the ship (by means of appropriate control electronics). Such electrical connection must allow the planar support structure 13 to be tilted without the connection being interrupted (this may be obtained, for example, with sliding contacts).

## Claims

1. Photovoltaic module installation structure, comprising a pair of parallel rails (11) configured to be fastened to a support surface (S), and a planar support element (13) mounted upon the rails (11), whereto the at least one photovoltaic module (1) is fastened, the planar support element (13) comprising a pair of end sides (13a, 13b) and a pair of lateral sides (13c, 13d), each of the lateral sides (13c, 13d) being coupled to one of the respective rails (11),
wherein each of the rails (11) comprises a rail side (11d) extending along a longitudinal direction of the rail (11) and facing the respective lateral side (13c, 13d) of the planar support element (13),
wherein each of the lateral sides (13c, 13d) of the planar support element (13) comprises a pair of pins (13c', 13c", 13d', 13d") respectively arranged at or near the end sides (13a, 13b) of the planar support element (13), said pins (13c', 13c", 13d', 13d") extending laterally from the respective lateral side (13c, 13d) of the planar support element (13) and resting upon the rail side (11d) of the respective rail (11),
wherein the planar support element (13) is rotatable with respect to the rails (11), about a tilting axis (y) defined by the pins (13c', 13c", 13d', 13d") and parallel to the end sides (13a, 13b) of the planar support element (13) and arranged near or at one of the end sides (13a, 13b) of the planar support element (13), said tilting axis (y) being slidable upon the rail side (11d) in such a way that the planar support element (13) is tiltable between a working position, wherein said at least one photovoltaic module (1) is exposed, and a protective position, wherein said at least one photovoltaic module (1) is hidden.

2. Installation structure according to claim 1, wherein in said working position and in said protective position the pins (13c', 13c", 13d', 13d") are arranged at respective end-of-travel positions along the respective rails (11).

3. Installation structure according to claim 1 or 2, wherein the planar support element (13) comprises a base plate (14) whereupon said at least one photovoltaic module (1) is arranged, and a protection frame (15) arranged around said base plate (14).

4. Installation structure according to claim 3, wherein the protection frame (15) has a cross-sectional profile comprising a C-shaped portion (15') extending along the entire length of the protection frame (15), and a plurality of L-shaped fins (15") extending along partial segments of the length of the protection frame (15), wherein the C-shaped portion (15') is arranged so as to encompass one edge of the base plate (14) and of said at least one photovoltaic module (1), and wherein the L-shaped fins (15") extend from the C-shaped portion (15') in a direction perpendicular to the base plate (14), and protrude with respect to a front surface of said at least one photovoltaic module (1) by a given distance (h).

5. Installation structure according to any of the preceding claims, further comprising, at each of the ends (11a, 11b) of each of the rails (11), a locking element (16) operable in order to lock a respective pin of said pins (13c', 13c", 13d', 13d") in a respective end-of-travel position along the respective rail (11).

6. Installation structure according to claim 5, wherein the locking element (16) is hinged to the respective end (11a, 11b) of the respective rail (11) and rotatable between a closed position and an open position, the locking element (16) comprising a notch (16d) configured so as to engage the respective pin of said pins (13c', 13c", 13d', 13d") in the closed position of the locking element.

7. Installation structure according to claim 5 or 6, wherein the locking element (16) further comprises a securing device (16a, 16b) configured so as to secure the locking element (16) in the closed position thereof.

8. Installation structure according to any of the preceding claims, wherein each of the rails (11) comprises a portion having an L-shaped cross-sectional profile, comprising a bottom side (11c) facing the support surface (S) and a rail side (11d) extending vertically from the bottom side (11c) alongside a respective lateral side (13c, 13d) of the planar support element (13), and wherein said pins (13c', 13c", 13d', 13d") are configured so as to rest and slide upon an upper edge (11d") of said rail side (11d).

9. Installation structure according to claim 8, wherein said upper edge (11d") comprises an inclined section (11f) at each end (11a, 11b) of the rail (11), said inclined section (11f) extending upwardly from the respective end (11a, 11b) towards the remaining central portion of the upper edge (11d").

10. Installation structure according to any of the preceding claims, wherein said pins (13c', 13c", 13d', 13d") are flanged pins.
